# EUROPEAN PATENT SPECIFICATION

(11) **EP 0 783 775 B1**
(45) Date of publication and mention of the grant of the patent: **03.05.2000**
(21) Application number: 95937430.7
(22) Date of filing: 28.09.1995
(51) Int. Cl.: H01R 12/04, H01R 12/32

(54) **SOLDER-BEARING LEAD AND METHOD OF PRODUCING AND USING SAME**
LOTTRAGENDER ANSCHLUSSDRAHT UND VERFAHREN ZU SEINER HERSTELLUNG UND VERWENDUNG
CONDUCTEUR PORTEUR DE SOUDURE A L'ETAIN ET PROCEDE DE SA FABRICATION

(30) Priority: 29.09.1994 US 315204; 08.08.1995 US 512508
(43) Date of publication of application: 16.07.1997
(73) Proprietor: NORTH AMERICAN SPECIALITIES CORPORATION, Flushing New York 11354 (US)
(72) Inventor: SEIDLER, Jack, Flushing, NY 11354 (US); POLLOCK, Leonard, J., Oceanside, NY 11572 (US)
(74) Representative: Gleiss, Alf-Olav, Dr.jur. Dipl.-Ing.
(86) International application number: US9513109
(87) International publication number: WO9610279

(56) References cited:
- US-A- 3 864 014
- US-A- 3 915 546
- US-A- 4 302 067
- US-A- 4 367 910
- US-A- 4 605 278
- US-A- 4 900 279
- US-A- 5 030 144

## Description

### FIELD OF THE INVENTION

This invention relates to solder-bearing leads for attachment to conductive pads on substrates, such as printed circuit boards, chip carriers, integrated circuits, or the like.

### DESCRIPTION OF RELATED ART AND BACKGROUND OF THE INVENTION

In the electronic equipment industry, it is common to provide leads for connection substrates, such as printed circuit boards, chip carriers, and the like, by soldering the leads to conductive pads on the substrate. See, for example, US-A-3 864 014 U.S. Patent No. 4,728,305 issued March 1, 1988 and No. 5,030,144 issued July 9, 1991. Such substrates commonly have a row of conductive pads or contact areas along one or more edges, for connection to an array of generally parallel leads spaced correspondingly to the pad spacing. The leads are commonly connected at one end to a longitudinally extending carrier strip, so that a section of the carrier strip having a ganged array of leads extending from it, may be applied to the row of pads along one edge of the substitute for simultaneously soldering the ganged array of leads to the row of pads.

The trend in this industry has been towards greater and greater miniaturization. As a result, the spacing between conductive pads of a substrate has been progressively reduced. While a pitch of 2.5 mm (0.100 inch, that is, 10 pads to the inch) has been common, the industry is moving more and more toward smaller pitches, such as 0.2 or 1.3 mm (0.75 or .050 inch) or even 0,5 mm (.020 inch). This requires a corresponding reduction of spacing and size of leads which are to be connected to such conductive pads.

In satisfying such needs for reduced spacing between leads, sufficient spacing must be nevertheless provided between the leads to prevent inadvertent contact or arcing between adjacent leads. This must be done without sacrificing accuracy in manufacture or impeding rapid assembly of multiple leads. A particular problem arises where the leads are solder-bearing, since in some instances the arrangement for holding the solder to the lead may encroach into the space between leads, or the lead blank may have lateral extensions thereby limiting how closely the leads may be spaced. See for example said U.S. Patent No. 4,728,305.

Accordingly, a need exists for solder-bearing leads of reduced size and spacing which are effectively applicable to accommodate reduced size and spacing of substrate conductive pads, but sufficiently spaced to prevent arcing, and to provide methods of manufacturing such leads without sacrificing accuracy.

### SUMMARY OF THE INVENTION

The present invention overcomes some of the problems and deficiencies of the prior art by providing solder-bearing leads of reduced size and spacing to accommodate the desired reductions in spacing of contact pads on substrates. Closer spacing of leads is attainable by eliminating lateral extensions of the leads which may intrude into the space between leads, and thus limit permissible spacing of such leads. In addition, at the same time, provision is made for effectively retaining one or more solder beads or slugs on each lead, without unduly intruding into the space between leads to such an extent as to prevent close spacing of leads. Also, provision is made to maintain direct metal-to-metal contact between lead and pad during soldering so that re-flow of the solder will not disturb the relation between lead and pad, and will provide a good solder joint.

The solder-bearing lead of the invention can be used, among other ways, as an edge clip for mounting to the edge of a substrate, or for surface mounting on a substrate. It can advantageously be made by automatic progressive stamping of blanks at high speed, in a continuous ganged array of leads held on one or more carrier strips, suitable for rolling up on a reel for convenience of transportation and ease of use in assembly to a chip carrier or other substrate.

The objects, features, and advantages of the present invention will be more completely understood by referring to the following detailed description of presently preferred embodiments of the present invention, taken with the attached drawings.

### BRIEF DESCRIPTION OF THE DRAWINGS

Figure 1 is a plan view of a portion of a continuous strip having a ganged array of lead blanks, each integral with a carrier strip, and useful in the present invention.

Figure 2 is a similar plan view of the arrangement of Figure 1, after subsequent forming operations at the intended solder location.

Figure 3 is an enlarged fragmentary plan view of a portion of one lead shown in Figure 2.

Figure 4 is a cross-sectional view of the structure of Figure 3, taken along line 4-4 thereof.

Figure 5 is a view similar to Figure 2, after placing a solder wire across a section of the array of leads.

Figure 6 is a plan view similar to Figure 5 after the solder wire is cut and formed around the solder location.

Figure 7 is an enlarged fragmentary transverse cross-sectional view of one lead of Figure 6 viewed along line 7-7 thereof.

Figure 8 is an enlarged fragmentary longitudinal cross-sectional view of a lead of Figure 6, viewed along line 8-8 thereof.

Figure 9 is an enlarged fragmentary side elevation view of the lead of Figures 6 to 8.

Figure 10 is a plan view of a fragment of a continuous strip of ganged leads according to a modified form of the invention, at an early stage of fabrication, with excess portions cut away to leave an array of lead blanks secured to a carrier strip.

Figure 11 shows a plan view similar to Figure 10 after a further fabrication step.

Figure 12 is an enlarged cross-section view of a lead of Figure 11, showing how the cross-section is reformed for accepting a solder mass.

Figure 13 shows a plan view similar to Figure 11 of a further stage in the fabrication of the leads according to the present invention, applying the solder by laying a solder wire across a section of the array of leads of Figure 11.

Figure 14 is an enlarged perspective view showing the relation of the solder wire to a lead in Figure 13.

Figure 15 is a plan view of a section of the array of leads of Figure 13, after the solder wire is cut and formed around the solder location of the lead.

Figure 16 is an enlarged transverse cross-sectional view of a lead of Figure 15 viewed along line 16-16 thereof.

Figure 17 is an enlarged longitudinal cross-sectional view of the solder-bearing portion of a lead of Figure 15 or 16, viewed along line 17-17 of Figure 16.

Figure 18 is an enlarged fragmentary side elevation view of lead as in Figures 15 to 17.

Figure 19 is a side elevation view partly in section of a substrate on which is mounted an edge clip having on one leg a solder mass formed as in Figures 1 to 9, preliminary to re-flow of the solder.

Figure 20 is a side elevation view similar to Figure 19, but having two solder masses, one on each face of the substrate.

Figure 21 is a side elevation view of a substrate positioned on an S-shaped lead of Figures 1 to 9.

Figure 22 is a side elevation view of a substrate with a lead of Figures 1 to 9 positioned to be surface mounted thereon.

Figure 23 is a side elevation view similar to Figure 20, with provision for extra security for retaining the solder mass on its lead.

Figure 24 is a side elevation view similar to Figure 20 showing a lead as in Figures 10 to 18 positioned on a substrate.

Figure 25 shows a plan view of a fragmentary portion of an arrangement of leads joined to a carrier strip for use in another embodiment of invention.

Figure 26 shows a plan view of an alternate form of the arrangement of Figure 25.

Figure 27 is a side elevation view of a portion of the arrangement of Figure 25.

Figure 28 shows a plan view of the lead arrangement of Figures 25 to 27 in association with a solder wire.

Figure 29 shows a cross-sectional side elevation view of a portion of Figure 28, viewed along line 28-28 thereof.

Figure 30 shows a side cross-sectional view of the lead arrangement of Figures 28 and 29, with a mechanism for joining the solder to the lead.

Figure 31 is a fragmentary cross-sectional view of a portion of Figure 30, viewed along line A-A thereof.

Figure 32 shows a plan view of a portion of the completed array of Figure 31, with leads with solder joined to a carrier strip.

Figure 33 shows a side elevation view of one utility for the device of Figures 25-32 using the present solder retention arrangement for a clip to be joined to a substrate.

Figure 34 shows a side elevation view of an arrangement for using the lead of Figures 25 to 32 of the present invention for surface mounting a component to a substrate.

### DETAILED DESCRIPTION OF PREFERRED EMBODIMENTS

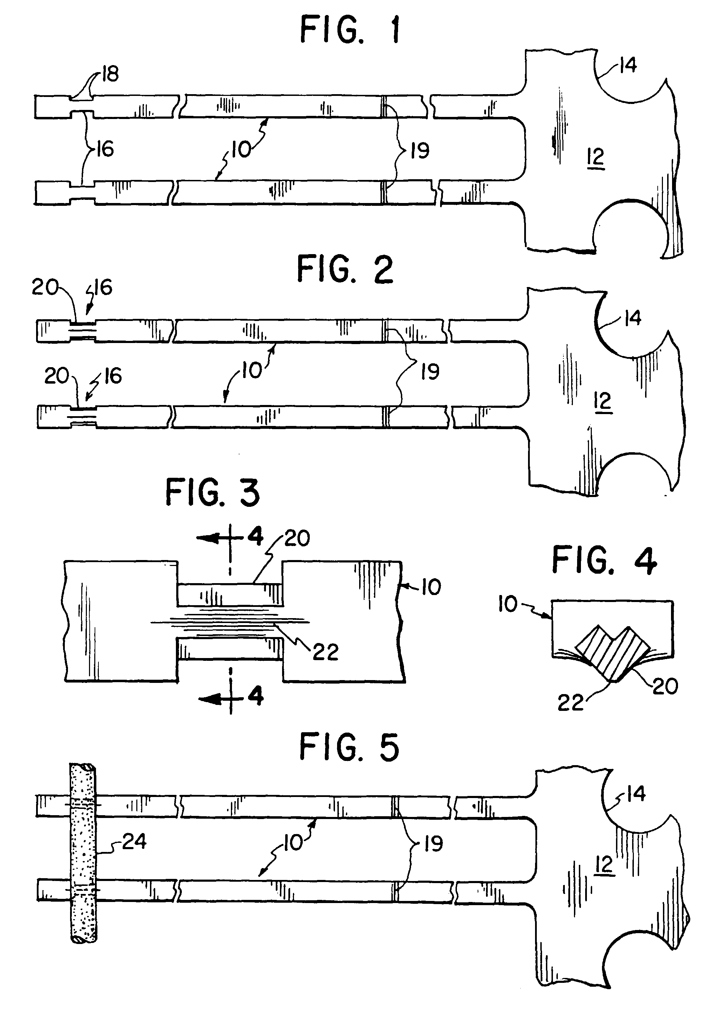

Referring now to the drawings, where like reference numerals represent corresponding parts in the several views, Figs. 1 to 9 show a first form of the invention. A continuous flat uniform slightly resilient strip of electrically conductive material (such as beryllium copper, brass or phosphor bronze, any of which may be pre-plated with solder or tin) of uniform thickness and width is passed through a progressive stamping machine to cut out extraneous material, leaving a stamped strip illustrated in Fig. 1, having a sequence of side-by-side individual lead blanks 10 joined integrally at one end to a carrier strip 12. As is customary, the carrier strip 12 may include periodically spaced holes 14 for indexing the strip through automatic stamping apparatus. In this form of the invention, at the position where a solder mass is to be held on the lead, each lead blank 10 has a reduced-width section 16. This section 16 is located along lead 10 at a position, depending upon the ultimate configuration of lead 10, where it is desired to retain a solder mass or bead. This reduced-width section 16 is joined to the main lead blank 10 by shoulders 18 at each end of section 16, which, as will be seen below, form stops or holding means to prevent longitudinal movement of the solder mass along the lead 10. At an appropriate position along each lead 10, it is provided with a transverse scoring or notch 19 which permits the lead 10 to be broken or cut away from the carrier strip 12.

According to one embodiment of the invention, the reduced-width section 16 is formed, as by stamping or pressing along its center line 21, into a generally V-shaped cross-section 20 illustrated in Figs. 2 to 4. The apex 22 of each V structure 20 projects slightly below the under surface of its lead 10 as shown most clearly in Fig. 4. This procedure may also reduce the width of section 20.

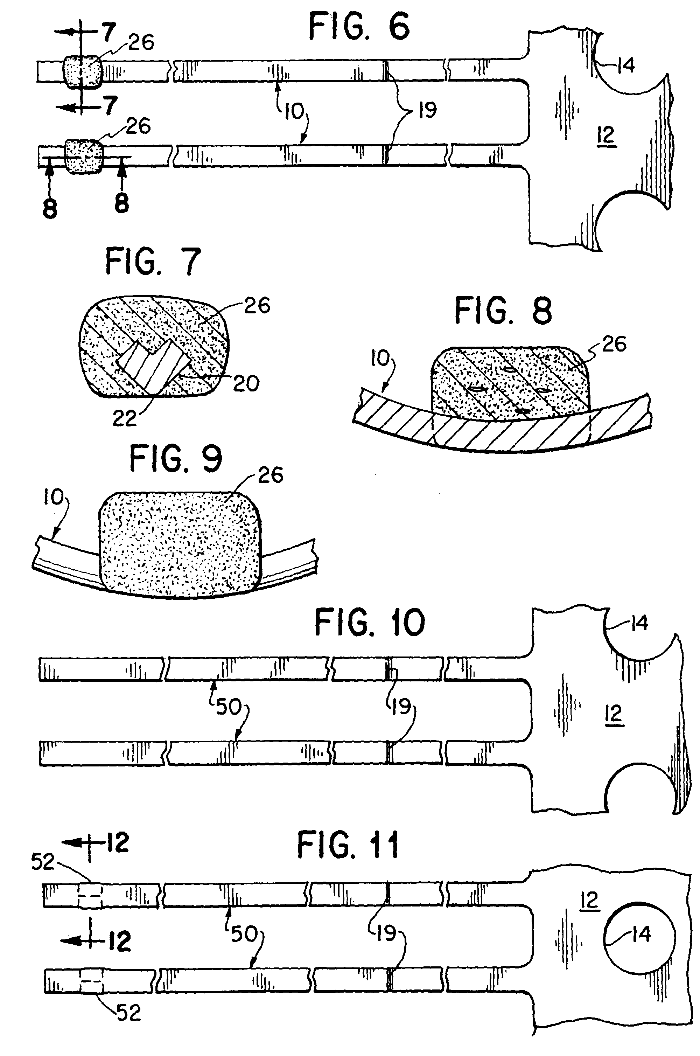

In a subsequent optional step of the process of fabrication, the lead is bent slightly, to form an obtuse angle or cradle, at the position of the reduced-width section 20. Then a solder wire or rod 24 is laid across a number of leads at the locations of their reduced-width sections 16, as illustrated in Fig. 5. Preferably the solder wire 24 contains rosin, as in its core, forming a solder flux. In a subsequent operation, the solder wire 24 is severed on each side of the reduced-width section 20 and then formed around the V-shaped section 20 as illustrated in Figs. 6 to 9 to form a solder bead generally surrounding narrowed section 20. It will be recognized that the solder material is highly malleable and therefore lends itself readily to such forming around the V-shaped section 20. As shown in Fig. 7, the width of the formed solder mass or bead 26 transverse to the lead 10, may be made substantially equal to or only slightly wider than the width of lead 10, so that the solder mass 26 encroaches only slightly or not at all into the space between successive leads 10, thereby permitting the leads to be closely spaced to conform to the substrate conductive pad spacing, which therefore may be substantially less than the conventional spacing of .050 inch. By appropriately selecting the diameter or cross-section of the solder wire 24, the height of the solder bead 26 may be made as large as necessary to provide the correct amount of solder for the proper solder joint to be made between each lead and its corresponding conductive pad.

As seen in Fig. 7, the solder 26 is caused to surround the V-shaped section 20 while not covering the apex 22. Also, the undercut provided by sloping sides of the V-shaped cross-section provides an interlock with the solder mass to prevent its accidental removal transversely of the lead 10, while the shoulders 18 serve to prevent longitudinal movement of the solder bead along the lead 10, so that the solder bead is retained reliably at the desired position.

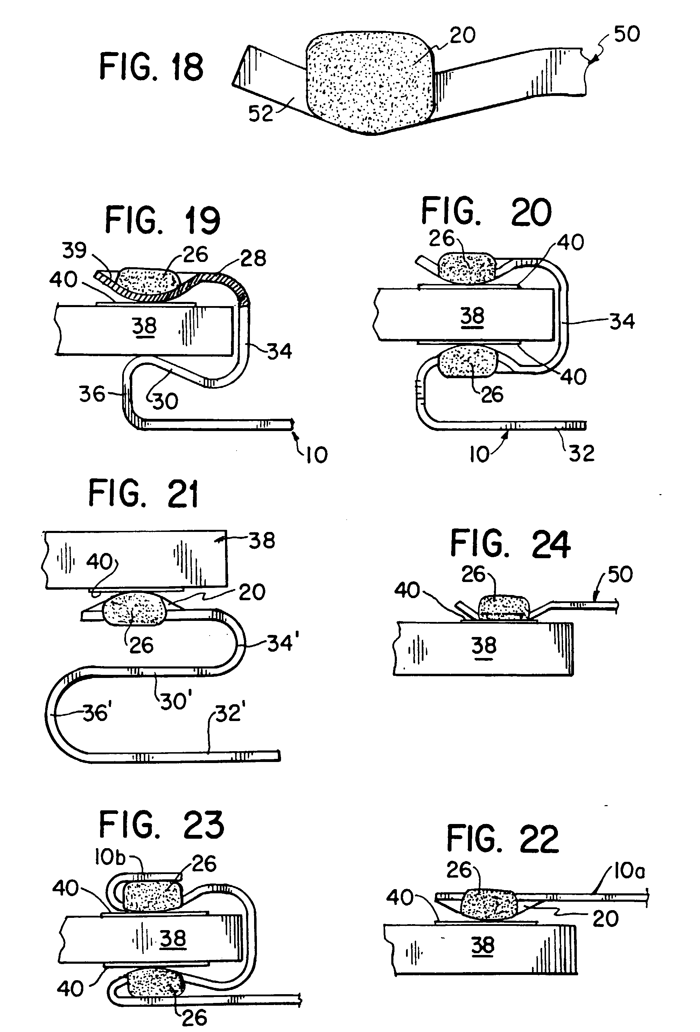

One form which a completed lead may take is shown in Fig. 19, having a generally S-shaped configuration. This configuration is formed by three generally parallel legs 28, 30, 32, with legs 28 and 30 joined by an appropriately shaped joining section 34, preferably curved in whole or in part, and legs 30 and 32 are also joined by a similar curved section 36. This configuration is adapted to receive a substrate 38 between upper leg 28 and central leg 32 of the S-shaped configuration, thereby providing a resilient clip mounting for the substrate 38 and reducing potentially harmful effects on the soldered joint which may be created by shock, vibration or differential thermal expansion.

The substrate 38 (which may be a chip carrier or an integrated circuit or a printed circuit board or the like) carries along one or more edges the usual linear array of conductive pads or contacts 40. In assembling clip leads such as in Fig. 19 to the substrate, a section of the carrier strip having a number of ganged leads 10 equal to the number of conductive pads 40 along an edge of the substrate, is cut off, and the clip-like arrangement of Fig. 19 is mounted on the substrate, with the solder mass 26 of each lead in contact with a corresponding substrate contact 40. The apex 22 of the lead's V-shaped section 20 then makes direct metal-to-metal contact with the conductive pad 40, with no solder in between. This provides the advantage that the lead 10 and pad 40 are readily maintained in desired fixed relation during soldering, which is not altered by subsequent re-flow or melting of the solder. The sloped outer end of the V-shaped section 26 and the adjoining flat portion 39 of lead 10 serve as a ramp or slope to facilitate entry of the substrate 38 between the legs 28 and 30.

While Fig. 19 shows a single solder bead, on one leg 28, it will be understood that one or more additional solder beads may be mounted on lead 10, in a fashion similar to bead 26. For example, a second similar solder mass may be formed on leg 30, as shown in Fig. 20, so as to permit soldering each lead 10 to conductive pads 44 on opposite faces of the substrate 38.

The outer leg or terminal portion 32 of the arrangement of Figs. 19 and 20 may be surface-mounted on a second substrate by a similar solder retaining arrangement (or any other soldering arrangement) on leg 32, or leg 32 may be extended to form a terminal for connection to other apparatus. For example, leg 32 may be bent at right angles to the position shown, and shaped to extend through a plated hole in a second substrate for perpendicular mounting and soldering to the second substrate.

Fig. 21 shows another arrangement, with lead 10 formed generally similarly to that of Fig. 19, but arranged to be soldered to a conductive pad 40 with the substrate on top of the lead 10 and solder bead 26.

Instead of forming a clip as in Figs. 19 or 20, the lead of the invention may be directly surface-mounted on a substrate by soldering the solder-bearing section to a substrate as shown in Fig. 22. The other end 10a of lead 10 may have any desired configuration, as required by apparatus to which it is to be connected.

In some instances, it may be desirable to give added security for retention of the solder on the lead, in any of the above-described forms of the invention. This may be done as shown in Fig. 23, which shows an edge clip similar to Fig. 20. Here, the lead portion 10b extending longitudinally outward from the solder bead 26 is bent over and closely juxtaposed to the solder 26 to further prevent movement of the solder mass away from lead 10. In addition, lower leg 32 of the lead 10 is bent to be close to the lower solder mass 26a, to aid in retaining it on the lead, if needed.

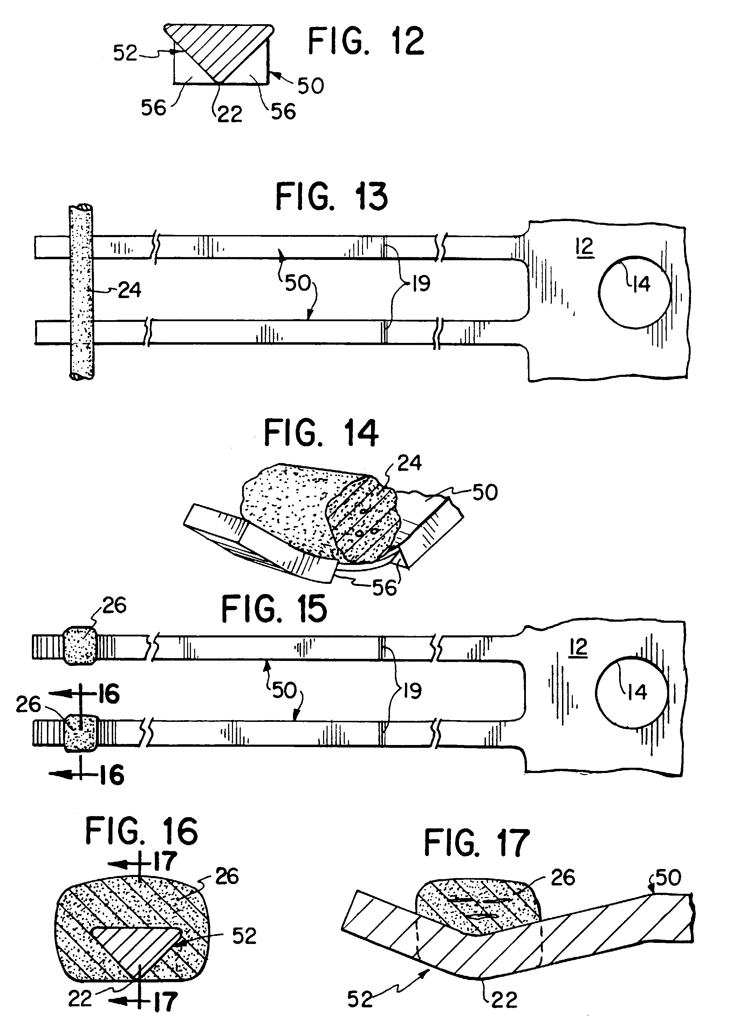

While the undercuts for retaining the solder mass on the lead are shown in Figs. 1 to 9 as formed by bending the lead body into a V-shape about a longitudinal axis, it will be understood that other ways of providing the undercuts and apex may be used. Thus, Figs. 10 to 18 illustrate stages in the fabrication of a modified form of the present invention. Fig. 10 shows the lead blanks formed by cutting out suitable portions of a continuous strip of conductive material to leave an array of flat leads 50 of uniform width attached at one end to and integral with the carrier strip 12. Instead of forming the V-shaped section as shown in Figs. 1 to 9, at the location of each lead where the solder lead is to be applied the lead is coined into a V-shape as shown in Figs. 11 and 12. This is done by applying pressure to the somewhat malleable lead, without removing material. The material formerly in the corners 54 of the leads 50 is moved away by this operation so that the width of the coined V-shaped section will be slightly larger than the original width of the leads 50, as seen in Fig. 12, or the upper surface of the lead may bulge upward. Shoulders indicated at 56 in Fig. 14 are formed at the ends of the coined section 58. While shown as squared off, these shoulders may be somewhat rounded or tapered. After thus forming the leads with a section 52 having a V-shaped cross-section, again a solder wire 24, preferably rosin-cored, is laid transversely of the leads 50 at the position of the V-shaped section 52, as shown in Fig. 13 and in perspective view in Fig. 14. The solder material is then again molded around the V-shaped coined section 56, as seen in transverse cross-section in Fig. 16 and in longitudinal cross-section in Fig. 17. Here again, as in the preceding form, the solder 24 does not extend substantially beyond apex 22 of the V, to allow the apex 22 to be placed in direct contact with a mating conductive pad.

By forming the solder 24 around the lead 50 at the coined V-shaped section 52, the solder bead 26 is retained against transverse movement by the undercut provided by the inwardly sloping sides of the V-shaped section, and the shoulder 56 at each end of the V-shaped section retains the solder bead against longitudinal movement. Again, the width of the solder bead 26 may be made equal to or only slightly wider than the width of the lead 10 or 50, so that in this arrangement as well as in the previously described one, leads may be relatively close together, since little if any portion of the leads extends into the space between the leads.

Thus, by the simple process of coining the V-shaped section instead of bending the lead into a V-shaped section, a similar profile is obtained, useful in the same way as described above, including Figs. 19 to 23. The solder-retaining arrangement described above with respect to Figs. 10 to 18 may thus be used in place of the arrangements of Figs. 1 to 9 described with respect to Figs. 19 to 23. Fig. 24 shows, in a fashion similar to Fig. 22, how each lead 50 with a solder bead 26 formed about a coined V-shaped section 52 may be positioned relative to a conductive pad 40 of a substrate 38, for soldering. As before, the lead body 50 may be formed as described into a variety of shapes known to the art, including edge clips or for surface-mounting, shown in Figs. 19 to 23.

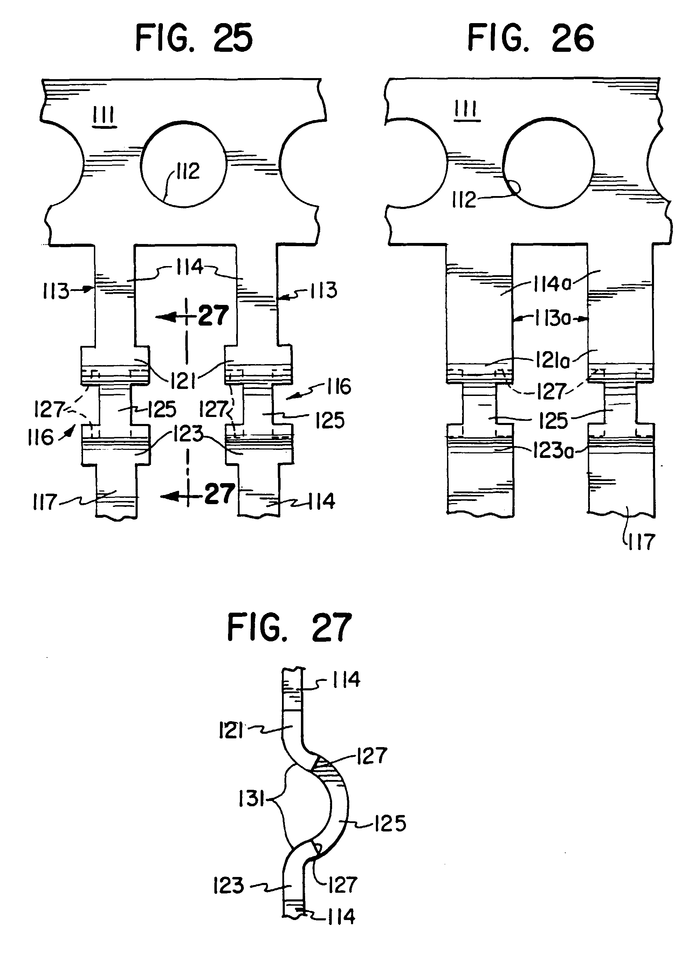

Figs. 25 to 34 show still another forming the present invention.

Fig. 1 shows a web of electrically conductive material, such as beryllium copper, of a thickness from 1.0 to 1.5 mm (.004 to .006 inch), formed with a carrier strip 111 with indexing holes 112 to permit step-wise advancement of the strip 111 along the multiple stages of a progressive stamping apparatus. Joined to the carrier strip 111 and extending laterally from it are a plurality of leads 113 each having a body section 114, a solder-bearing section 116 and a terminal section 117. The body section 114 will generally be of uniform thickness and width. The terminal section 117 may have any desired configuration for joining to other electrical components or apparatus, such as for surface mounting on a substrate, or connection to an electrical component, or having a compliant pin formation such as shown in U.S. Patent No. 4,752,250 of Jack Seidler issued June 21, 1988.

In the form of Fig. 25, the solder-retaining section 16 has slightly wider end sections 121, 123 spaced apart by a narrow section 125 joined to the end sections 121, 123 by shoulders 127. In a representative version of this arrangement the end sections 121, 123 may have a width between 0.30 and 0.35 mm (.012 and .014 inch), the body portion 114 may have a width of about 0,2 mm (.008 inch), and the narrowed section 125 may have a width between 0,15 and 0.2 mm (.006 and .008 inch). This permits the center-to-center spacing or pitch of the leads along the carrier strip 111 to be much smaller than for conventional leads, and may be of the order of .020 inch.

Each lead has its solder-bearing portion 125 bowed or bent into a cradle-like form as shown in Fig. 25. The bends 131 joining the cradle 125 to the lead body portion 114 are formed preferably at the location of the end sections 121, 123 so that the shoulders 127 are partially within the cradle formed by the bowed section 125. The bowed section 125 is preferably made arcuate with an inner radius of approximately .009 inches.

As shown in the alternate form of Fig. 26, the end portions 121a, 123a of the solder-bearing portion 125 may have a width equal to that of the lead body portion 114. The following description is directed toward the arrangement of Fig. 25 but it will be understood that the same description is applicable also to Fig. 26.

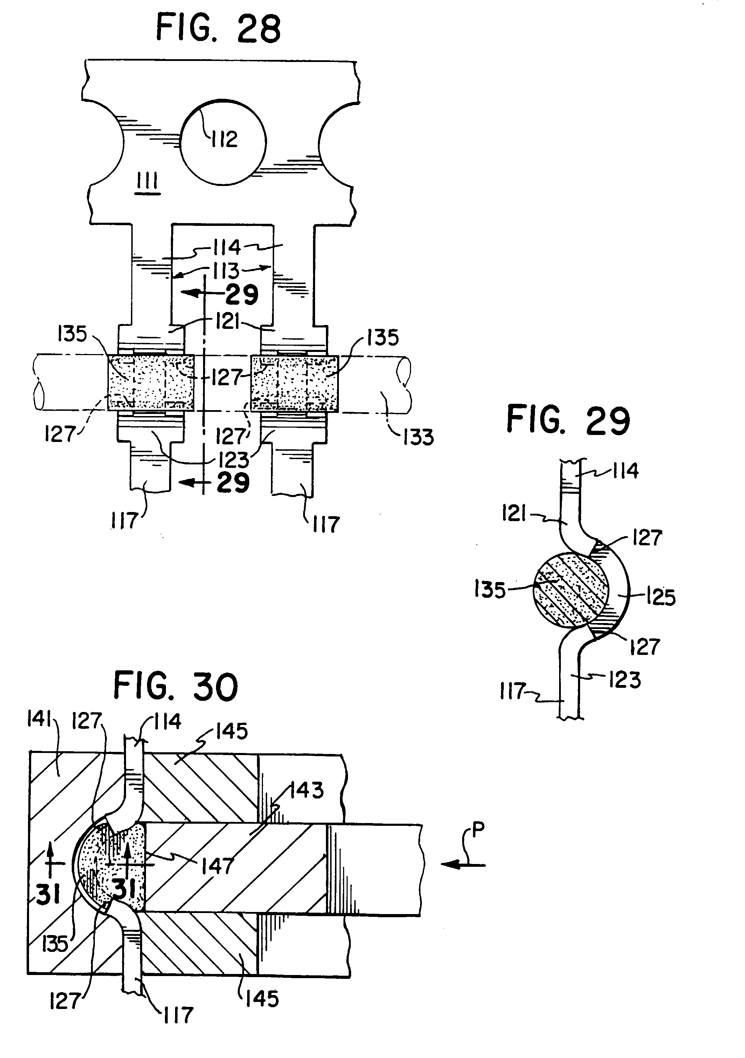

As shown in Fig. 27, a solder wire 133 is laid across several of the leads 113 in the course of the progressive stamping procedure. The solder wire 133 has a diameter corresponding to the curvature of the cradles 125 of the leads. This is illustrated in the dash dot dot lines of Fig. 27 and illustrated in Fig. 28.

In a subsequent stage of the progressive stamping, each lead is placed between a die 141 and a punch 143 supported for sliding movement between a pair of support tools 145. By moving the punch 143 in the direction shown by the arrow 147, the malleable solder wire is forced around the side edges of the cradle 125 and in so doing engages behind the edges of the shoulders 127, as seen in Fig. 30. Preferably the punch 143 presses the solder 133 sufficiently to flatten the solder to produce a flattened surface 147 approximately co-planar with the lead body 14 and terminal section 117, as seen in Fig. 30. This compression of the solder forces it around the side edges of the bend 125 and into engagement with the shoulders 127 which serve to retain the solder mass 135 from being pulled away from the lead 113. Concurrently with or about the same time as the step of compressing or molding the solder around the narrowed section 125, the solder wire 133 is cut on either side of the lead 113 to provide a discrete solder mass 135 for each lead 113.

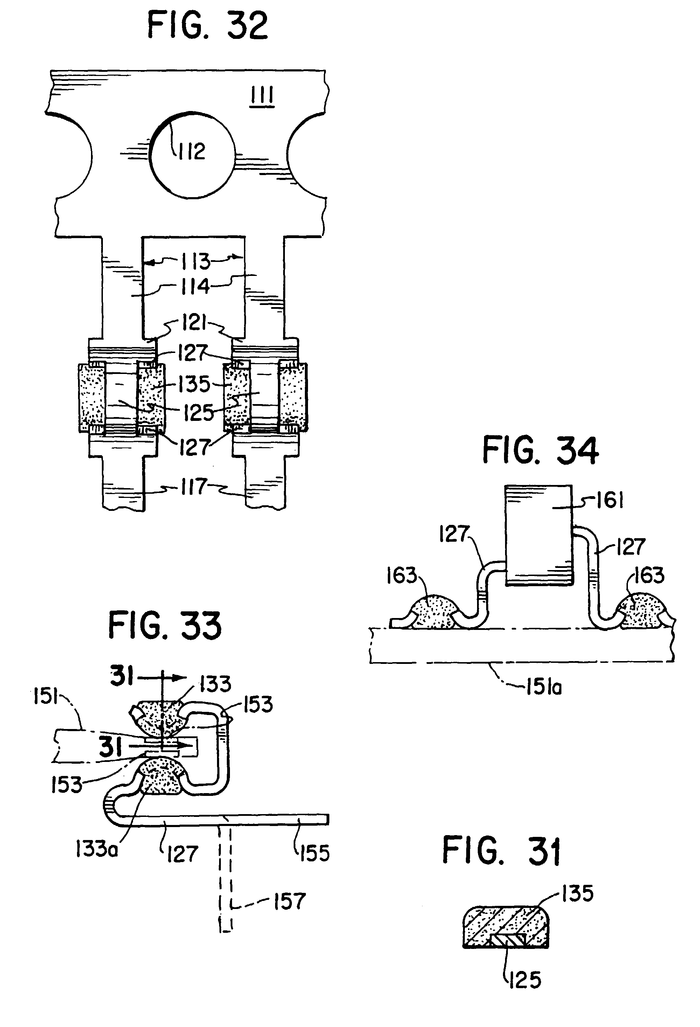

As illustrated in Fig. 31, the outer surfaces of the bends 125 remain uncovered by the solder and thereby permit the desirable metal-to-metal contact between each lead and the pad to which it is to be joined, at the time of solder reflow to provide the soldered joint. This permits the lead to be retained precisely against the contact pad during the solder reflow and avoids the possibility of shifting of leads relative to their pads, which might otherwise occur if solder between the leads and the pads liquifies during reflow.

The molding of the solder around the edges of the shoulders 127 retains this solder against the lead and prevents transverse movement of the solder with respect to the lead. The shoulders 127 also prevent any longitudinal movement of the solder relative to the lead. Lateral solder movement is prevented by the solder encirclement of the edges of the narrowed bends 25, as seen in Figs. 31 and 32. This provides an arrangement for effectively retaining the solder mass with respect to the lead during further handling, until reflow and re-solidification of the solder.

Fig. 32 shows a plan view seen from the underside of Fig. 28, showing the solder masses 135 beneath the solder-retaining sections 125, after the compressing step of Fig. 30.

Fig. 33 shows the solder retaining arrangement of Fig. 33 used in a clip to join to a substrate. In this arrangement two such solder-bearing arrangements are formed on each lead, which is then bent into a C-shaped arrangement with the solder-bearing portions opposed to one another. This forms a gap into which can be inserted a substrate 151 having contact pads 153 to which the solder masses 133 and 133a may be joined. The terminal portion 127 may be formed as desired, either parallel to the substrate 151 as at 155 or perpendicular thereto as at 157, for connection to other circuit elements, or may be formed to be mounted perpendicular to a further substrate in plated holes thereof, as a compliant pin disclosed in U.S. Patent No. 4,752,250 or straight terminal as disclosed in U.S. Patent No. 4,883,435, or 4,932,876 or 5,139,448, whose disclosures are incorporated herein by these references.

Fig. 34 shows a diagrammatically a circuit component 161 to which are connected lead terminal portions 127 terminating in the solder-retaining structure 163 shown in preceding figures, arranged here for surface mounting on a substrate 151a. The leads of Figs. 25 to 34 may also be formed and used in the same manner as described with respect to Figs. 19 to 24.

As seen in Fig. 31, the solder surrounds both edges of said narrowed section and thereby prevents lateral movement of the solder mass from the narrowed section. In addition, when the solder-bearing portion of the lead is juxtaposed to a pad or other contact to which it is to be soldered, the outer metal surface of the narrowed section will make direct contact with the pad, permitting accurate placement and retention of the lead in position prior and during to solder reflow. In addition, when the solder is reflowed, the portions of the solder mass bordering the inner surface of the narrowed section will flow readily around the bend of its outer surface so as to form a good electrical and mechanical joint between the lead and the pad.

In assembling the leads of any of the forms described above to a chip carrier or other substrate having a row of contact pads along one or more edges, a section of the carrier strip is cut off, the section including a number of leads corresponding to the number and spacing of contacts on the substrate. While held together by the carrier strip, the leads are positioned in contact with the respective pads, so that the apex of the undercut portion of each lead or the portion not covered by solder makes direct contact with the corresponding pad. The ganged array of leads may be held against the pads by the resilience of the clip arrangement when a configuration as in Fig. 19 is used. Otherwise the leads and pads may be held in position by suitable fixtures. The solder is then re-flowed, and then cooled, which joins each lead to a pad both electrically and mechanically. Thereafter the carrier strip is severed or broken away, as by the notch construction 19. The other ends of the leads may then be connected suitably to other devices.

By way of example, the leads of the present invention may be spaced more closely even then the present general minimum pitch of 1,3 mm (.050 inch, 20 to the inch). As an illustration (but not limitation) of the miniature dimensions attainable with the present invention, each lead of Figs. 1 to 9 may have a width of 0,25 to 0,38 mm (.010 to .015 inch), with a thickness of 0,13 to 0,20 mm (.005 to .008 inch). The reduced-width section 16 of Figs. 1 to 9 may be between 0,13 to 0,20 mm (.005 and .008 inch) wide and 0,25 to 0,30 mm (.010 to .012 inch) long. The apex 22 of the V-shaped section 20 in Figs. 1 to 9 may project below the lead under surface by 0,025 to 0,075 mm (.001 to .003 inch). Corresponding dimensions may be used for the form of Figs. 10 to 18. Therefore, pitches of as small as 1 to 6 mm (.040 to .025 inch, 25 to 40 leads per inch) may be provided without creating short circuits between the leads or after soldering between the conductive pads to which they are soldered.

It will be understood that, while the V-shaped profile of the solder-retaining section is a simply attainable and a desirable form, other profiles may be used, as shown in Figs. 25 to 34, for example. The present invention provides for interlocking or retaining the solder bead to the lead without preventing metal-to-metal contact between lead and its corresponding conductive pad or contact during soldering. Thus, without departing from essential aspects of the invention, the V-shaped profile may be modified to have a curved form or a stepped form. Also the solder-retaining section profile may be formed in other ways, as by suitably removing materials from the lower corners of the edges of the leads to provide the desired undercut, and apex or tip.

It will be understood that the invention is not to be limited by the specific embodiments shown in the drawings and described in the above description, which are given by way of example and not of limitation, but only in accordance with the scope of the appended claims.

## Claims

1. A method of producing solder-bearing leads comprising the steps of:
forming a flat elongated web of electrically conductive material to have a longitudinally extending carrier strip section (12) and a plurality of lead blanks (10) extending laterally therefrom, said lead blanks (10) being spaced in correspondence with the spacing of conductive pads (40) on integrated circuits, printed circuit boards or the like (38), to which the leads are designed to be soldered,
forming each lead blank (10) to have two uniform width body sections (50), and a reduced width narrower solder-bearing section (16) intermediate said body sections (50), said body sections (50) forming a shoulder (18) at each end of said narrower solder-bearing section (16),
placing solder material (26) on a first side of said narrower section,
compressing said solder material (26) to cause it to flow against and around the side edges of said narrower section (16), characterized in that at least a portion of a second side of said narrower section (16) is left exposed for contact with an element (40) to which said lead (10) is to be soldered.

2. A method as in claim 1, wherein said solder material (26) is in the form of solder wire (24), and further comprising the step of
cutting said solder wire (24) adjacent each edge of said narrower section (16) to form a solder mass (26) retained by said shoulders (18) on said lead body (50) against longitudinal displacement and retained against lateral and transverse displacement by said narrower section (16).

3. A method as in claim 1, further comprising
bending said narrower solder-bearing section (16) to form a cradle (20), with said shoulders (18) being within and adjacent the ends of said cradle, said solder-bearing section (16) having an inner surface and an outer surface,
and placing said solder material wire (24) in said cradle (20) on its inner surface,
said compressing leaving part of said outer cradle surface uncovered by solder.

4. A method as in claim 3, further comprising
said compressing causing said solder material (26) to flow into contact with said shoulders (18) to substantially cover said inner cradle surface and the edges of said narrower section (16) with solder material (26) juxtaposed to said shoulders,
causing said solder material (26) to have a surface substantially co-planar with said lead body portions (10) with the outer surface of the narrow section (16) being left exposed for contact with an element (40) to which said lead (10) is to be soldered.

5. A method as in claim 3 comprising the steps of:
bending said narrower solder-bearing section (16) into an arcuate shape to form a cradle (20) with said shoulders (18) being within and adjacent the ends of said arcuate form to form undercuts, said solder-bearing section (16) having an inner surface and an outer surface, and
partially enveloping said narrow section (16) with solder material (26), said material (26) substantially covering said inner surface and the edges of said narrower section (16) and juxtaposed to said shoulders (18).

6. A method as in claim 5, wherein
said enveloping step comprises
causing said solder material (26) to have a surface substantially co-planar with said lead body portions (50), with the outer surface of the narrow section (16) being left uncovered by solder (26) for contact with an element (40) to which said lead (10) is to be soldered, and
cutting said solder wire (24) adjacent each edge of said cradle (20) to form a solder mass (26) retained on said lead body (10) against transverse and longitudinal displacement by said shoulders (18), and against lateral displacement by partially enveloping said narrower section (16).

7. The method of claim 1, wherein each body section (50) has a first surface and said solder material (26) does not extend substantially beyond said first surface of one of said body sections (50) further comprising assembling said leads on a lead less substrate having a row of conductive pads thereon by :
positioning said plurality of lead blanks (10) which are equal in number to the number of pads (40) in a row, with each lead solder bearing section (16) juxtaposed to a corresponding pad (40), the leads (10) being held in their relative position by said carrier strip (12).
causing said reflowed solder (26) to cool to join each lead (10) electrically and mechanically to its corresponding pad (40), and
after cooling, removing said carrier strip (12) of said lead blanks (10).

8. A method as in claim 7, comprising the steps of
providing a solder-bearing portion (16), having a cross-section with undercuts at the edges and a tip extending longitudinally of said lead, said tip extending transversely of said lead at least as far as the surface of the lead adjoining said solder-bearing portion (16), each lead having a solder mass (26) surrounding its said solder-bearing portion and engaging said undercuts without extending substantially beyond said tip, and
said positioning includes positioning said ganged array of leads (10) with said tip of each lead (10) juxtaposed to a corresponding pad (40), the leads of said lead array being held in their relative positions by said carrier strip (12).

9. A method as in claim 8, wherein said substrate (38) has conductive pads (40) along a plurality of edges thereof, and said steps are applied as to each substrate edge having conductive pads (40).

10. A method as in claim 8, wherein said tips extend transversely beyond the adjoining lead portions.

11. The method of claim 1, wherein said solder material (26) extends partially around said reduced width section (16), and leaves uncovered a portion substantially contiguous with a surface of one of said body sections (50).

12. A method as in claim 11, further including
bending a portion of said lead body (50) adjoining said re-formed section (16) around said solder mass (26),
whereby said solder mass (26) is retained more securely on said lead (10).

13. A method as in claim 11, wherein said re-forming comprises coining said body section (50), to form a substantially V-shaped profile for the cross-section of said lead body section.

14. A method as in claim 11, wherein said re-forming comprises bending said body lead section (50) about a longitudinal axis thereof to form a cross-section with a tapered profile forming said undercuts and tip.

15. A method as in claim 11, comprising:
reducing the width of said body section by cutting out edge portions thereof.

16. A method as in claim 11, wherein said reforming comprises:
bending said body section (50) along a line extending centrally thereof to form a substantial V-shaped cross-section (20) for said lead body section (50).

17. The method as in claim 11, comprising the steps of:
reducing the width of a section (16) of said body portion (50) to have a width narrower than said uniform lead body portion (50) and with a shoulder (18) between each end of said narrower section (16) and said body portion (50),
bending each said lead blank (10) to form an arcuate section including said narrower section (16), said arcuate section (20) forming a solder-receiving cradle (20) having an inner surface and an outer surface,
placing a malleable solder mass (26) on said cradle inner surface,
compressing the solder mass (26) in said cradle (20) against said cradle inner surface to mold said solder (26) at least partially around said narrower section (16) and to be substantially co-planar with said lead lower surface, with said cradle narrower section outer surface exposed.

18. The method as in claim 11, comprising the steps of:
forming said reduced-width section (16) of said body (50) between said portions to have a width less than said uniform lead body portions (50) and with a shoulder (18) between each end of said narrower section (16) and a respective body portion (50)
bending said lead blank (10) to form an arcuate section including said narrower section (16) and the shoulders (18) at each end thereof, said arcuate section forming a solder-receiving cradle (20) having an inner surface and an outer surface,
placing a malleable solder wire (24) in said cradle,
cutting off said wire (24) adjacent each side of said cradle (20) to leave a solder mass (26) in said cradle,
compressing the solder mass (26) in said cradle (20) against said cradle inner surface to mold said solder (26) around the edges of said narrower section (16) and said shoulders (18) and to be substantially co-planar with said lead lower surface,
whereby said solder mass (26) is retained against longitudinal and transverse movement by said shoulders (18) and against lateral movement by said narrower section edges, with the outer surface of said cradle narrower section exposed.

19. A solder-bearing lead (10) for connection to a substrate conductive pad (40) comprising
an elongated lead body (50) of electrically conductive material, said lead body (50) having a section with substantially uniform width and thickness with an upper surface and a lower surface,
said lead body (50) having a longitudinally extending solder-bearing portion (16) at a predetermined position along said lead body and adjoining said uniform width and thickness section of said lead body,
said solder-bearing portion (16) having a reduced width narrower cross-section with undercuts thereon,
said lead having a shoulder (18) between said uniform width and thickness body section (50) and said reduced width narrower solder-bearing portion (16),
a solder mass (26) extending around said undercuts,
whereby said solder mass (26) is prevented from longitudinal movement by said shoulder (18) and from transverse movement by said undercuts, characterized in that said solder mass (26) partially surrounds said solder-bearing portion (16), but leaves a portion of said solder-bearing portion (16) uncovered, and said lead (10) may be soldered to a corresponding pad (40) by placing said uncovered portion in contact with said pad (40) and reflowing said solder mass (26).

20. A solder-bearing lead as in claim 19, wherein said solder-bearing lead portion (16) has a V-shaped cross-section, said undercuts being provided by the sloping sides of said V and said uncovered portion being the vertex of said V.

21. A lead as in claim 20, wherein said vertex extends beyond said lead body lower surface.

22. A lead as in claim 19, wherein said solder-bearing portion has a bend therein,
said shoulders (18) being with said bend and providing undercuts for retaining said solder mass (26) on said lead (10).

23. A solder-bearing lead (10) as in claim 19, for connection to a substrate conductive pad (40) wherein
whereby said solder mass (26) is retained against longitudinal and transverse movement by said shoulders (18) and against lateral movement by said narrower section edges, with the outer surface of said cradle narrower section exposed.

24. A connector arrangement for a substrate (38) having a row of conductive pads (40), comprising a plurality of solder-bearing leads (10) as set forth in claim 19, and further comprising a carrier strip (12) of electrically conductive material of substantially uniform thickness, from which said plurality of leads (10) extend laterally, each lead (10) being integrally connected to said carrier strip (12) at one end of the lead, said leads (10) being parallel and spaced corresponding to said pads (40).

25. A connector arrangement as in claim 24, in which
said solder-bearing portion (16) has a generally V-shaped profile in cross-section, with the vertex of said V-shaped profile extending transversely at least to the lower surface of said flat body portion.

26. A connector arrangement as in claim 24, where said uncovered portion extends beyond the lower surface of said flat body portion (50).

27. A connector arrangement as in claim 25, wherein said narrower solder-bearing portion (16) is bent about a longitudinal axis to form said V-shape and said uncovered portion,
said solder mass (26) partially surrounding said solder-bearing portion (16) does not extend substantially beyond said lead body surface.

## Patentansprüche

1. Verfahren zum Erzeugen von lottragenden Anschlußdrähten, das folgende Schritte umfaßt:
Formen eines flachen länglichen Bands aus elektrisch leitendem Material, so daß es einen sich in Längsrichtung erstreckenden Trägerstreifenabschnitt (12) und mehrere sich von dort erstreckende Anschlußdrahtrohlinge (10) aufweist, wobei die Anschlußdrahtrohlinge (10) entsprechend dem Abstand von leitenden Lötaugen (40) auf integrierten Schaltungen, Leiterplatten oder dergleichen (38) an die die Anschlußdrähte angelötet werden sollen, beabstandet sind,
Formen jedes Anschlußdrahtrohlings (10), so daß er zwei Körperabschnitte (50) gleichförmiger Breite und zwischen den Körperabschnitten (50) einen schmaleren lottragenden Abschnitt (16) reduzierter Breite aufweist, wobei die Körperabschnitte (50) an jedem Ende des schmaleren lottragenden Abschnitts (16) eine Schulter (18) bilden,
Plazieren von Lotmaterial (26) auf einer ersten Seite des schmaleren Abschnitts,
Zusammendrücken des Lotmaterials (26), um zu bewirken, daß es gegen und um die Seitenkanten des schmaleren Abschnitts (16) fließt, dadurch gekennzeichnet, daß mindestens ein Teil einer zweiten Seite des schmaleren Abschnitts (16) zum Kontakt mit einem Element (40), an das der Anschlußdraht (10) angelötet werden soll, freigelassen wird.

2. Verfahren nach Anspruch 1, bei dem das Lotmaterial (26) in Form von Lötdraht (24) vorliegt, und weiter mit folgendem Schritt:
Schneiden des Lötdrahts (24) neben jeder Kante des schmaleren Abschnitts (16), um eine Lötmasse (26) zu bilden, die von den Schultern (18) an dem Anschlußdrahtkörper (50) gegen Längsverschiebung gehalten wird und durch den schmaleren Abschnitt (16) gegen seitliche und Querverschiebung gehalten wird.

3. Verfahren nach Anspruch 1, weiterhin mit folgendem:
Biegen des schmaleren lottragenden Abschnitts (16), um einen Träger (20) zu formen, wobei die Schultern (18) innerhalb der Enden und neben den Enden des Trägers sind, wobei der lottragende Abschnitt (16) eine Innenfläche und eine Außenfläche aufweist,
und Plazieren des Lotmaterialdrahts (24) in dem Träger (20) auf seiner Innenfläche,
wobei das Zusammendrücken einen Teil der Trägeraußenfläche durch Lot unbedeckt läßt.

4. Verfahren nach Anspruch 3, weiterhin mit folgendem:
das Zusammendrücken bewirkt, daß das Lotmaterial (26) in Kontakt mit den Schultern (18) fließt, um die Trägerinnenfläche und die Kanten des schmaleren Abschnitts (16) mit neben den Schultern angeordnetem Lotmaterial (26) im wesentlichen zu bedecken,
Bewirken, daß das Lotmaterial (26) eine Fläche aufweist, die im wesentlichen in der gleichen Ebene mit den Anschlußdrahtkörperteilen (10) liegt, wobei die Außenfläche des schmaleren Abschnitts (16) zum Kontakt mit einem Element (40), an das der Anschlußdraht (10) angelötet werden soll, freigelassen wird.

5. Verfahren nach Anspruch 3, das folgende Schritte umfaßt:
Biegen des schmaleren lottragenden Abschnitts (16) zu einer Bogenform, um einen Träger (20) zu formen, wobei die Schultern (18) innerhalb der Enden und neben den Enden der Bogenform liegen, um Hinterschneidungen zu bilden, wobei der lottragende Abschnitt (16) eine Innenfläche und eine Außenfläche aufweist, und
teilweises Umhüllen des schmalen Abschnitts (16) mit Lotmaterial (26), wobei das Material (26) die Innenfläche und die Kanten des schmaleren Abschnitts (16) im wesentlichen bedeckt und neben den Schultern (18) angeordnet ist.

6. Verfahren nach Anspruch 5, bei dem der Umhüllungsschritt folgendes umfaßt:
Bewirken, daß das Lotmaterial (26) eine Fläche aufweist, die im wesentlichen in der gleichen Ebene mit den Anschlußdrahtkörperteilen (50) liegt, wobei die Außenfläche des schmalen Abschnitts (16) für Kontakt mit einem Element (40), an das der Anschlußdraht (10) angelötet werden soll, durch Lot (26) unbedeckt gelassen wird, und
Schneiden des Lötdrahts (24) neben jeder Kante des Trägers (20), um eine Lötmasse (26) zu formen, die auf dem Anschlußdrahtkörper (10) gegen Quer- und Längsverschiebung durch die Schultern (18) und gegen seitliche Verschiebung durch teilweises Umhüllen des schmaleren Abschnitts (16) gehalten wird.

7. Verfahren nach Anspruch 1, bei dem jeder Körperabschnitt (50) eine erste Fläche aufweist und das Lotmaterial (26) sich nicht wesentlich über die erste Fläche eines der Körperabschnitte (50) erstreckt, weiterhin mit dem Anbringen der Anschlußdrähte an einem anschlußdrahtlosen Substrat mit einer Reihe von darauf befindlichen leitenden Lötaugen durch:
Positionieren der mehreren Anschlußdrahtrohlinge (10), deren Anzahl gleich der Anzahl von Lötaugen (40) in einer Reihe ist, wobei jeder lottragende Abschnitt (16) neben einem entsprechenden Lötauge (40) angeordnet ist, wobei die Anschlußdrähte (10) durch den Trägerstreifen (12) in ihrer relativen Position gehalten werden,
Bewirken, daß das aufgeschmolzene Lot (26) abkühlt, um jeden Anschlußdraht (10) elektrisch und mechanisch mit einem entsprechenden Lötauge (40) zu verbinden, und
nach dem Kühlen, Entfernen des Trägerstreifens (12) der Anschlußdrahtrohlinge (10).

8. Verfahren nach Anspruch 7, das folgende Schritte umfaßt:
Bereitstellen eines lottragenden Teils (16) mit einem Querschnitt, der an den Kanten hinterschneidet, und einer Spitze, die sich in Längsrichtung des Anschlußdrahts erstreckt, wobei sich die Spitze quer zu dem Anschlußdraht mindestens bis zu der Fläche des Anschlußdrahts erstreckt, der an den lottragenden Teil (16) anschließt, wobei jeder Anschlußdraht eine Lötmasse (26) aufweist, die seinen lottragenden Teil umgibt und die Hinterschneidungen in Eingriff nimmt, ohne sich wesentlich über die Spitze zu erstrecken, und
wobei das Positionieren das Positionieren des gekuppelten Arrays von Anschlußdrähten (10) einschließt, wobei die Spitze jedes Anschlußdrahts (10) neben einem entsprechenden Lötauge (40) angeordnet ist, wobei die Anschlußdrähte des Anschlußdrahtarrays durch den Trägerstreifen (12) in ihrer relativen Position gehalten werden.

9. Verfahren nach Anspruch 8, bei dem das Substrat (38) entlang mehrerer seiner Kanten leitende Lötaugen (40) aufweist und die Schritte auf jede Substratkante mit leitenden Lötaugen (40) angewendet werden.

10. Verfahren nach Anspruch 8, bei dem sich die Spitzen quer über die angrenzenden Anschlußdrahtteile erstrecken.

11. Verfahren nach Anspruch 1, bei dem sich das Lotmaterial (26) teilweise um den Abschnitt (16) reduzierter Breite erstreckt und einen im wesentlichen mit einer Fläche einer der Körperabschnitte (50) zusammenhängenden Teil freiläßt.

12. Verfahren nach Anspruch 11, weiterhin mit folgendem:
Biegen eines Teils des Anschlußdrahtkörpers (50) neben dem umgeformten Abschnitt (16) um die Lötmasse (26),
wobei die Lötmasse (26) sicherer an dem Anschlußdraht (10) gehalten wird.

13. Verfahren nach Anspruch 11, bei dem das Umformen das Prägen des Körperabschnitts (50) umfaßt, um ein im wesentlichen V-förmiges Profil für den Querschnitt des Anschlußdrahtkörperabschnitts zu bilden.

14. Verfahren nach Anspruch 11, bei dem das Umformen das Biegen des Anschlußdrahtkörperabschnitts (50) um seine Längsachse umfaßt, um einen Querschnitt mit einem sich verjüngenden Profil zu bilden, das die Hinterschneidungen und die Spitze formt.

15. Verfahren nach Anspruch 11, das folgendes umfaßt:
Reduzieren der Breite des Körperabschnitts, indem aus ihm Kantenteile ausgeschnitten werden.

16. Verfahren nach Anspruch 11, bei dem das Umformen folgendes umfaßt:
Biegen des Körperabschnitts (50) entlang einer Linie, die sich mittig davon erstreckt, um einen im wesentlichen V-förmigen Querschnitt (20) für den Anschlußdrahtkörperabschnitt (50) zu bilden.

17. Verfahren nach Anspruch 11, das folgende Schritte umfaßt:
Reduzieren der Breite eines Abschnitts (16) des Körperteils (50), um eine Breite zu haben, die schmaler ist als der gleichförmige Anschlußdrahtkörperteil (50), und mit einer Schulter (18) zwischen jedem Ende des schmaleren Abschnitts (16) und dem Körperteil (50),
Biegen jedes Anschlußdrahtrohlings (10), um einen bogenförmigen Abschnitt zu formen, der den schmaleren Abschnitt (16) enthält, wobei der bogenförmige Abschnitt (20) einen lotaufnehmenden Träger (20) mit einer Innenfläche und einer Außenfläche bildet,
Plazieren einer hämmerbaren Lötmasse (26) auf der Trägerinnenfläche,
Zusammendrücken der Lötmasse (26) in dem Träger (20) gegen die Trägerinnenfläche, um das Lot (26) so zu formen, daß es sich mindestens teilweise um den schmaleren Abschnitt (16) befindet und im wesentlichen in einer Ebene mit der unteren Fläche des Anschlußdrahts befindet, wobei die Außenfläche des schmaleren Abschnitts des Trägers freiliegt.

18. Verfahren nach Anspruch 11, mit den folgenden Schritten:
Formen des Abschnitts (16) reduzierter Breite des Körpers (50) zwischen den Teilen, um eine Breite aufzuweisen, die unter den gleichförmigen Anschlußdrahtkörperteilen (50) liegt, und mit einer Schulter (18) zwischen jedem Ende des schmaleren Abschnitts (16) und einem jeweiligen Körperteil (50),
Biegen des Anschlußdrahtrohlings (10), um einen bogenförmigen Abschnitt zu formen, der an jedem Ende den schmaleren Abschnitt (16) und die Schultern (18) enthält, wobei der bogenförmige Abschnitt einen lotaufnehmenden Träger (20) mit einer Innenfläche und einer Außenfläche bildet,
Plazieren eines hämmerbare Lötdrahts (24) in dem Träger,
Abschneiden des Drahts (24) neben jeder Seite des Trägers (20), um eine Lötmasse (26) in dem Träger zu lassen,
Zusammendrücken der Lötmasse (26) in dem Träger (20) gegen die Trägerinnenfläche, um das Lot (26) so zu formen, daß es um die Kanten des schmaleren Abschnitts (16) und die Schultern (18) liegt und im wesentlichen in einer Ebene mit der unteren Fläche des Anschlußdrahts liegt,
wodurch die Lötmasse (26) gegen Längs- und Querbewegung durch die Schultern (18) und gegen seitliche Bewegung durch die Kanten des schmaleren Abschnitts gehalten wird, wobei die Außenfläche des schmaleren Abschnitts des Trägers freiliegt.

19. Lottragender Anschlußdraht (10) zur Verbindung mit einem leitenden Lötauge (40) auf einem Substrat, der folgendes umfaßt:
einen länglichen Anschlußdrahtkörper (50) aus elektrisch leitendem Material, wobei der Anschlußdrahtkörper (50) einen Abschnitt mit im wesentlichen gleichförmiger Breite und Dicke mit einer oberen Fläche und einer unteren Fläche aufweist,
wobei der Anschlußdrahtkörper (50) einen sich in Längsrichtung erstreckenden lottragenden Teil (16) an einer vorbestimmten Position entlang dem Anschlußdrahtkörper und neben dem Abschnitt mit gleichförmiger Breite und Dicke des Anschlußdrahtkörpers aufweist,
wobei der lottragende Teil (16) einen schmaleren Querschnitt reduzierter Breite mit Hinterschneidungen daran aufweist,
wobei der Anschlußdraht eine Schulter (18) zwischen dem Körperabschnitt (50) gleichförmiger Breite und Dicke und dem schmaleren lottragenden Teil (16) reduzierter Breite aufweist,
wobei sich eine Lötmasse (26) um die Hinterschneidungen erstreckt,
wodurch die Lötmasse (26) an einer Längsbewegung durch die Schulter (18) und an einer Querbewegung durch die Hinterschneidungen gehindert wird, dadurch gekennzeichnet, daß die Lötmasse (26) den lottragenden Teil (16) teilweise umgibt, aber einen Teil des lottragenden Teils (16) unbedeckt läßt und der Anschlußdraht (10) an ein entsprechendes Lötauge (40) gelötet werden kann, indem der unbedeckte Teil in Kontakt mit dem Lötauge (40) plaziert wird und die Lötmasse (26) aufgeschmolzen wird.

20. Lottragender Anschlußdraht nach Anspruch 19, wobei der lottragende Anschlußdrahtteil (16) einen V-förmigen Querschnitt aufweist, wobei die Hinterschneidungen durch die schrägen Seiten des V bereitgestellt werden und der unbedeckte Teil die Spitze des V ist.

21. Anschlußdraht nach Anspruch 20, bei dem sich die Spitze über die untere Fläche des Anschlußdrahtkörpers hinaus erstreckt.

22. Anschlußdraht nach Anspruch 19, bei dem in dem lottragenden Teil eine Biegung vorliegt,
wobei die Schultern (18) bei der Biegung sind und Hinterschneidungen zum Halten der Lötmasse (26) an dem Anschlußdraht (10) bereitstellen.

23. Lottragender Anschlußdraht (10) nach Anspruch 19 zur Verbindung mit einem leitenden Lötauge (40) auf einem Substrat, bei dem die Lötmasse (26) gegen Längs- und Querbewegung durch die Schultern (18) und gegen seitliche Bewegung durch die Kanten des schmaleren Abschnitts gehalten wird, wobei die Außenfläche des schmaleren Abschnitts des Trägers freiliegt.

24. Verbinderanordnung für ein Substrat (38) mit einer Reihe von leitenden Lötaugen (40), mit mehreren lottragenden Anschlußdrähten (10) nach Anspruch 19, und weiterhin mit einem Trägerstreifen (12) aus elektrisch leitendem Material mit im wesentlichen gleichförmiger Dicke, von dem sich die mehreren Anschlußdrähte (10) seitlich erstrecken, wobei jeder Anschlußdraht (10) integral mit dem Trägerstreifen (12) an einem Ende des Anschlußdrahts verbunden ist, wobei die Anschlußdrähte (10) parallel sind und entsprechend den Lötaugen (40) beabstandet sind.

25. Verbinderanordnung nach Anspruch 24, bei der der lottragende Teil (16) im Querschnitt ein im allgemeinen V-förmiges Profil aufweist, wobei sich die Spitze des V-förmigen Profils mindestens zu der unteren Fläche des flachen Körperteils quer erstreckt.

26. Verbinderanordnung nach Anspruch 24, bei der der unbedeckte Teil sich über die untere Fläche des flachen Körperteils (50) erstreckt.

27. Verbinderanordnung nach Anspruch 25, bei dem der schmalere lottragende Teil (16) um eine Längsachse gebogen ist, um eine V-Form und den unbedeckten Teil zu bilden,
wobei die Lötmasse (26), die den lottragenden Teil (16) teilweise umgibt, sich nicht wesentlich über die Anschlußdrahtkörperfläche hinaus erstreckt.

## Revendications

1. Procédé de fabrication de conducteurs porteurs de soudure comprenant les étapes consistant à :
mettre en forme un tissu plat allongé de matériau électriquement conducteur de manière à avoir une section de bande support s'étendant de façon longitudinale (12) et une pluralité de pièces vierges de conducteurs (10) s'étendant latéralement par rapport à celle-ci, lesdites pièces vierges de conducteurs (10) étant espacées en correspondance avec l'espacement de plots conducteurs (40) sur des circuits intégrés, des cartes de circuits imprimés ou analogue (38), auxquels il est prévu que les conducteurs soient soudés,
mettre en forme chaque pièce vierge de conducteurs (10) de manière à avoir deux sections de corps de largeur uniforme (50) et une section porteuse de soudure plus étroite de largeur réduite (16) intermédiaire entre lesdites sections de corps-(50), lesdites sections de corps (50) formant un épaulement (18) à chaque extrémité de ladite section porteuse de soudure plus étroite (16),
placer du matériau de soudure (26) sur un premier côté de ladite section plus étroite,
comprimer ledit matériau de soudure (26) pour le faire s'écouler contre et autour des bords latéraux de ladite section plus étroite (16),
caractérisé en ce qu'au moins une portion d'un deuxième côté de ladite section plus étroite (16) est laissée apparente pour contact avec un élément (40) auquel doit être soudé ledit conducteur (10).

2. Procédé selon la revendication 1, dans lequel ledit matériau de soudure (26) est sous la forme d'un fil de soudure (24) et comprenant en outre les étapes consistant à
découper ledit fil de soudure (24) de manière adjacente à chaque bord de ladite section plus étroite (16) de façon à former une masse de soudure (26) retenue par lesdits épaulements (18) sur ledit corps de conducteur (50) à l'encontre d'un déplacement longitudinal et retenue à l'encontre d'un déplacement latéral transversal par ladite section plus étroite (16).

3. Procédé selon la revendication 1, comprenant en outre
le pliage de ladite section porteuse de soudure plus étroite (16) de manière à former un berceau (20), lesdits épaulements (18) étant situés à l'intérieur et adjacents aux extrémités dudit berceau, ladite section porteuse de soudure (16) ayant une surface interne et une surface externe,
et placer ledit fil de matériau de soudure (24) dans ledit berceau (20) sur sa surface interne,
ladite compression laissant une partie de ladite surface de berceau externe non recouverte par de la soudure.

4. Procédé selon la revendication 3, comprenant en outre
le fluage par ladite compression dudit matériau de soudure (26) en contact avec lesdits épaulements (18) pour couvrir sensiblement ladite surface de berceau interne et les bords de ladite section plus étroite (16) avec du matériau de soudure (26) juxtaposé auxdits épaulements,
le fait de conférer audit matériau de soudure (26) une surface sensiblement coplanaire avec lesdites portions de corps de conducteurs (10), la surface externe de la section étroite (16) étant laissée apparente pour contact avec un élément (40) auquel ledit conducteur (10) doit être soudé.

5. Procédé selon la revendication 3, comprenant les étapes consistant à :
plier ladite section porteuse de soudure plus étroite (16) selon une forme courbe pour former un berceau (20), lesdits épaulements (18) étant situés à l'intérieur et adjacents aux extrémités de ladite forme courbe, de manière à former des évidements, ladite section porteuse de soudure (16) ayant une surface interne et une surface externe, et
envelopper partiellement ladite section étroite (16) avec du matériau de soudure (26), ledit matériau (26) couvrant sensiblement ladite surface interne et les bords de ladite section plus étroite (16) et étant juxtaposé auxdits épaulements (18).

6. Procédé selon la revendication 5, dans lequel
ladite étape d'enveloppement comprend
le fait de conférer audit matériau de soudure (26) une surface sensiblement coplanaire avec lesdites portions de corps de conducteur (50), la surface externe de la section étroite (16) étant laissée non recouverte par de la soudure (26) pour contact avec un élément (40) auquel ledit conducteur (10) doit être soudé, et
la découpe dudit fil de soudure (24) de manière adjacente à chaque bord dudit berceau (20), de manière à former une masse de soudure (26) retenue sur ledit corps de conducteur (10) à l'encontre d'un déplacement transversal et longitudinal par lesdits épaulements (18) et à l'encontre d'un déplacement latéral en enveloppant partiellement ladite section plus étroite (16).

7. Procédé selon la revendication 1, dans lequel chaque section de corps (50) comporte une première surface et ledit matériau de soudure (26) ne se prolonge sensiblement pas au-delà de ladite première surface de l'une desdites sections de corps (50), comprenant en outre l'assemblage desdits conducteurs sur un substrat sans conducteur comportant une rangée de plots conducteurs sur celui-ci par :
positionnement de ladite pluralité de pièces vierges de conducteurs (10) en nombre égal au nombre de plots (40) dans une rangée, chaque section porteuse de soudure de conducteur (16) étant juxtaposée à un plot correspondant (40), les conducteurs (10) étant maintenus dans leur position relative par ladite bande support (12),
refroidissement de ladite soudure refondue (26) pour réunir chaque conducteur (10) électriquement et mécaniquement à son plot correspondant (40), et
après refroidissement, retrait de ladite bande support (12) desdites pièces vierges de conducteurs (10).

8. Procédé selon la revendication 7, comprenant les étapes consistant à
fournir une portion porteuse de soudure (16) ayant une section transversale avec des évidements sur les bords et une extrémité s'étendant de façon longitudinale par rapport audit conducteur, ladite extrémité s'étendant transversalement par rapport audit conducteur au moins aussi loin que la surface du conducteur voisine de ladite portion porteuse de soudure (16), chaque conducteur comportant une masse de soudure (26) entourant sa dite portion porteuse de soudure et s'engageant dans lesdits évidements sans s'étendre sensiblement au-delà de ladite extrémité, et
effectuer ledit positionnement comportant le positionnement de ladite matrice de conducteurs liés (10), chaque extrémité de chaque conducteur (10) étant juxtaposée à un plot correspondant (40), les conducteurs de ladite matrice de conducteurs étant maintenus dans leur position relative par ladite bande support (12).

9. Procédé selon la revendication 8, dans lequel ledit substrat (38) comporte des plots conducteurs (40) le long d'une pluralité de ses bords et lesdites étapes sont appliquées à chaque bord de substrat comportant des plots conducteurs (40).

10. Procédé selon la revendication 8, dans lequel lesdites extrémités s'étendent transversalement au-delà des portions de conducteurs voisines.

11. Procédé selon la revendication 1, dans lequel ledit matériau de soudure (26) s'étend partiellement autour de ladite section de largeur réduite (16) et laisse non couverte une portion sensiblement contiguë avec une surface de l'une desdites sections de corps (50).

12. Procédé selon la revendication 11, comportant en outre
le pliage d'une portion dudit corps de conducteur (50) voisine de ladite section remise en forme (16) autour de ladite masse de soudure (26),
de façon à ce que ladite masse de soudure (26) soit retenue de manière plus sûre sur ledit conducteur (10).

13. Procédé selon la revendication 11, dans lequel ladite reformation comprend le redressement de ladite section de corps (50), de manière à former un profil sensiblement en forme de V pour la section transversale de ladite section de corps de conducteur.

14. Procédé selon la revendication 11, dans lequel ladite reformation comprend le pliage de ladite section de corps de conducteur (50) autour d'un axe longitudinal de celle-ci de manière à former une coupe transversale avec un profil effilé formant lesdits évidements et extrémité.

15. Procédé selon la revendication 11, comprenant :
la réduction de la largeur de ladite section de corps par découpe des portions de bord de celle-ci.

16. Procédé selon la revendication 11, dans lequel ladite reformation comprend :
le pliage de ladite section de corps (50) le long d'une ligne s'étendant de manière centrale à celle-ci afin de former une section transversale sensiblement en forme de V (20) pour ladite section de corps de conducteur (50).

17. Procédé selon la revendication 11, comprenant les étapes consistant à :
diminuer la largeur d'une section (16) de ladite portion de corps (50) de façon à avoir une largeur plus étroite que ladite portion de corps de conducteur uniforme (50) et avec un épaulement (18) entre chaque extrémité de ladite section plus étroite (16) et ladite portion de corps (50),
plier chaque dite pièce vierge de conducteur (10) pour former une section courbe comportant ladite section plus étroite (16), ladite section courbe (20) formant un berceau recevant de la soudure (20) ayant une surface interne et une surface externe,
placer une masse de soudure malléable (26) sur ladite surface interne du berceau,
comprimer la masse de soudure (26) dans ledit berceau (20) contre ladite surface interne du berceau, de manière à mouler ladite soudure (26) au moins partiellement autour de ladite section plus étroite (16) et pour être sensiblement coplanaire avec ladite surface inférieure de conducteur, ladite surface externe de la section plus étroite du berceau étant apparente.

18. Procédé selon la revendication 11, comprenant les étapes consistant à :
mettre en forme ladite section de largeur réduite (16) dudit corps (50) entre lesdites portions de manière à avoir une largeur inférieure auxdites portions de corps de conducteur uniformes (50) et avec un épaulement (18) entre chaque extrémité de ladite section plus étroite (16) et une portion de corps respective (50)
plier ladite pièce vierge de conducteur (10) de manière à former une section courbe comportant ladite section plus étroite (16) et les épaulements (18) à chaque extrémité de celle-ci, ladite section courbe formant un berceau recevant de la soudure (20) ayant une surface interne et une surface externe,
placer un fil de soudure malléable (24) dans ledit berceau,
découper ledit fil (24) adjacent à chaque côté dudit berceau (20) de manière à laisser une masse de soudure (26) dans ledit berceau,
comprimer la masse de soudure (26) dans ledit berceau (20) contre ladite surface interne du berceau pour mouler ladite soudure (26) autour des bords de ladite section plus étroite (16) et desdits épaulements (18) et de manière à être sensiblement coplanaire avec ladite surface inférieure de conducteur,
de façon à ce que ladite masse de soudure (26) soit retenue à l'encontre d'un mouvement longitudinal et transversal par lesdits épaulements (18) et à l'encontre d'un mouvement latéral par lesdits bords de section plus étroite, la surface externe de ladite section de berceau plus étroite étant apparente.

19. Conducteur porteur de soudure (10) pour connexion à un plot conducteur d'un substrat (40) comprenant
un corps de conducteur allongé (50) de matériau électriquement conducteur, ledit corps de conducteur (50) ayant une section avec une largeur et une épaisseur sensiblement uniformes avec une surface supérieure et une surface inférieure,
ledit corps de conducteur (50) comportant une portion porteuse de soudure s'étendant de façon longitudinale (16) dans une position prédéterminée le long dudit corps de conducteur et voisine de ladite section de largeur et d'épaisseur uniformes dudit corps de conducteur,
ladite portion porteuse de soudure (16) ayant une section transversale plus étroite de largeur réduite avec des évidements sur celle-ci,
ledit conducteur comportant un épaulement (18) entre ladite section de corps de largeur et d'épaisseur uniformes (50) et ladite portion porteuse de soudure plus étroite de largeur réduite (16),
une masse de soudure (26) s'étendant autour desdits évidements ;
de façon à ce que ladite masse de soudure (26) soit empêchée d'un mouvement longitudinal par ledit épaulement (18) et d'un mouvement transversal par lesdits évidements,
caractérisé en ce que ladite masse de soudure (26) entoure partiellement ladite portion porteuse de soudure (16), mais laisse non couverte une portion de ladite portion porteuse de soudure (16) et ledit conducteur (10) peut être soudé à un plot correspondant (40) en plaçant ladite portion non couverte en contact avec ledit plot (40) et en refondant ladite masse de soudure (26).

20. Conducteur porteur de soudure selon la revendication 19, dans lequel ladite portion de conducteur porteuse de soudure (16) a une coupe transversale en forme de V, lesdits évidements étant constitués par les côtés en pente dudit V et ladite portion non couverte étant le sommet dudit V.

21. Conducteur selon la revendication 20, dans lequel ledit sommet s'étend au-delà de ladite surface inférieure du corps conducteur.

22. Conducteur selon la revendication 19, dans lequel ladite portion porteuse de soudure comporte une courbure dans celle-ci,
lesdits épaulements (18) étant avec ladite courbure et constituant des évidements pour retenir ladite masse de soudure (26) sur ledit conducteur (10).

23. Conducteur porteur de soudure (10) selon la revendication 19, pour connexion à un plot conducteur d'un substrat (40), dans lequel
ladite masse de soudure (26) est retenue à l'encontre d'un mouvement longitudinal et transversal par lesdits épaulements (18) et à l'encontre d'un mouvement latéral par lesdits bords de section plus étroite, avec la surface externe de ladite section de berceau plus étroite apparente.

24. Dispositif de connecteur pour un substrat (38) comportant une rangée de plots conducteurs (40), comprenant une pluralité de conducteurs porteurs de soudure (10) selon la revendication 19 et comprenant en outre une bande support (12) de matériau électriquement conducteur d'épaisseur sensiblement uniforme, à partir de laquelle ladite pluralité de conducteurs (10) s'étendent latéralement, chaque conducteur (10) étant connecté de manière intégrée à ladite bande support (12) à une extrémité du conducteur, lesdits conducteurs (10) étant parallèles et espacés d'une manière correspondant auxdits plots (40).

25. Dispositif de connecteur selon la revendication 24, dans lequel
ladite portion porteuse de soudure (16) a un profil en forme générale de V en coupe, le sommet dudit profil en forme de V s'étendant transversalement au moins par rapport à la surface inférieure de ladite portion de corps plate.

26. Dispositif de connecteur selon la revendication 24, dans lequel ladite portion non couverte s'étend au-delà de la surface inférieure de ladite portion de corps plate (50).

27. Dispositif de connecteur selon la revendication 25, dans lequel ladite portion porteuse de soudure plus étroite (16) est pliée autour d'un axe longitudinal de manière à former ladite forme en V et ladite portion non couverte,
ladite masse de soudure (26) entourant partiellement ladite portion porteuse de soudure (16) ne s'étend sensiblement pas au-delà de ladite surface de corps de conducteur.
